# EUROPÄISCHE PATENTANMELDUNG

(11) **EP 1 001 670 A2**
(43) Veröffentlichungstag der Anmeldung: **17.05.2000**
(21) Anmeldenummer: 99118907.7
(22) Anmeldetag: 24.09.1999
(51) Int. Cl.: H05K 7/14, H05K 9/00

(54) **Baugruppenträger**

(30) Priorität: 09.11.1998 DE 19851590
(71) Anmelder: VERO Electronics GmbH, 28279 Bremen (DE)
(72) Erfinder: Borschewski, Dietmar, 28197 Bremen (DE); Schröder, Rainer, 27721 Ritterhude (DE)
(74) Vertreter: Bohnenberger, Johannes, Dr.

(57) **Zusammenfassung**

Baugruppenträger (1), insbesondere ein 19"-Gehäuse, mit einer ersten Seitenwand (4), einer zweiten Seitenwand, einer Rückwand, einer oberen Abdeckung (3), einer unteren Abdeckung (13) und einer Frontabdeckung, wobei im Baugruppenträger mindestens eine HF-Dichtung (2A, 2B) vorgesehen ist.

Um einen HF-dichten Baugruppenträger realisieren zu können, der Eckprofile aufweist, ist erfindungsgemäß vorgesehen, daß der Baugruppenträger mit mindestens einem Eckprofil (5) versehen ist, wobei das Eckprofil (5) im Abschlußbereich mit der oberen und/oder der unteren Abdeckung (3, 13) und/oder im Abschlußbereich mit der oberen und/oder der unteren Abschlußfläche (14, 15) einer Seitenwand (4) mit mindestens einer Aussparung (10, 11) zur Aufnahme jeweils einer HF-Dichtung (2A, 2B) - oder umgekehrt - versehen ist.

## Beschreibung

Die Erfindung betrifft einen Baugruppenträger, insbesondere ein 19"-Gehäuse, entsprechend dem Oberbegriff des Anspruchs 1.

Solche Baugruppenträger dienen typischerweise der Aufnahme von Leiterplatten, wie insbesondere von sogenannten Europakarten mit Frontplatten, wobei auf den Leiterplatten elektronische Bauelemente angeordnet sind. Um die auf den Leiterplatten vorgesehenen elektronischen Bauelemente vor dem negativen Einfluß von HF-Strahlung zu schützen, wird der Baugruppenträger üblicherweise mit einer HF-Abschirmung versehen.

Aus der DE-C1-42 05 893 ist ein Baugruppenträger bekannt, bei dem Maßnahmen ergriffen worden sind, um zu verhindern, daß störende HF-Strahlung in den Baugruppenträger eindringt und in dem Baugruppenträger angeordnete elektronische Bauelemente stört. Bei dem bekannten Baugruppenträger ist eine Frontplatte unter Zwischenlage einer HF-Dichtung auf den übrigen Baugruppenträger aufgeschraubt.

Bei sogenannten Rack-, Tisch- und Toweraufbauten von Baugruppenträgern finden zunehmend Baugruppenträger Verwendung, die Eckprofile aufweisen, die als Blend- und/oder Griffprofile dienen.

Obwohl erwünscht, hat man bislang davon abgesehen, solche Eckprofile bei HF-dichten Baugruppenträgern zu verwenden, weil mit einer größeren Anzahl von Einzelkomponenten, die das Gehäuse des HF-dichten Baugruppenträgers bilden, zwangsläufig eine größere Anzahl von Spalten bzw. Ritzen am Gehäuse des HF-dichten Baugruppenträgers einhergeht. Eine große Anzahl Spalten bzw. Ritzen am Gehäuse eines HF-dichten Baugruppenträgers führt zu einer verminderten HF-Abschirmung des Baugruppenträgers.

Daher liegt der Erfindung die Aufgabe zugrunde, einen HF-dichten Baugruppenträger der eingangs genannten Art dahingehend weiterzubilden, daß trotz an dem Baugruppenträger vorgesehener Eckprofile, wie Blend- und/oder Griffprofile, eine ausreichende HF-Dichtigkeit gegeben ist.

Ein wesentlicher Aspekt der Erfindung besteht darin, die Eckprofile des Baugruppenträgers im Abschlußbereich sowohl mit der oberen als auch der unteren Abdeckung des Baugruppenträgers jeweils mit einer Aussparung zur Aufnahme jeweils einer HF-Dichtung zu versehen, um die ansonsten vorhandenen Ritzen mit der HF-Dichtung zu schließen.

Ein weiterer Aspekt der Erfindung besteht darin, die Eckprofile auch in den Abschlußbereichen sowohl mit der oberen als auch der unteren Abschlußfläche einer Seitenwand jeweils mit einer Aussparung zur Aufnahme jeweils einer HF-Dichtung zu versehen, um die ansonsten auch hier vorhandenen Ritzen HF-dicht zu verschließen.

Es versteht sich, daß entsprechende Aussparungen zur Aufnahme von HF-Dichtungen nicht am Eckprofil, sondern alternativ an der oberen bzw. unteren Abdeckung und/oder an der Seitenwand des Baugruppenträgers vorgesehen sein können. Ebenso kann es sich um Aussparungen handeln, die sich sowohl im Eckprofil als auch in der oberen und/oder unteren Abdeckung oder im Eckprofil und/oder in der Seitenwand des Baugruppenträgers zur Aufnahme von HF-Dichtungen erstrecken.

Weitere vorteilhafte Ausgestaltungen der Erfindung sind in den Unteransprüchen angegeben.

Die Erfindung wird nachfolgend anhand von nicht notwendigerweise maßstäblichen Zeichnungen näher beschrieben, wobei gleiche oder gleich wirkende Teile mit denselben Bezugszeichen versehen sind und darum nicht nochmals näher erläutert werden. Es zeigen:
- Fig. 1: einen HF-dichten Baugruppenträger, beispielhaft mit einem Eckprofil an der linken Frontseite des Baugruppenträgers, das im Abschlußbereich zur Seitenwand und der oberen Abdeckung mit zwei Aussparungen zur Aufnahme von HF-Dichtungen versehen ist;
- Fig. 2: die Anordnung der Aussparungen am Eckprofil der Fig. 1 in einer vergrößerten Darstellung;
- Fig. 3: die Kontaktfläche der linken Seitenwand mit dem Eckprofil der Erfindung;
- Fig. 4: eine HF-Abdichtung zwischen der Schmalseite der oberen Abdeckung und der Seitenwand;
- Fig. 5: die HF-Abdichtung gemäß Fig. 4 in einer vergrößerten Darstellung;
- Fig. 6: die HF-Abdichtung gemäß Fig. 5 nach der Montage der oberen Abdeckung auf der Seitenwand;
- Fig. 7: einen HF-dichten Baugruppenträger mit einer Tür an der Frontseite und Kontaktzungenkörpern im Türöffnungsbereich;
- Fig. 8: den Türöffnungsbereich des HF-dichten Baugruppenträgers der Fig. 7 im Längsschnitt;
- Fig. 9: die Anordnung der Kontaktzungenkörper im Türöffnungsbereich;
- Fig. 10: einen Kontaktzungenkörper in einer vergrößerten Darstellung;

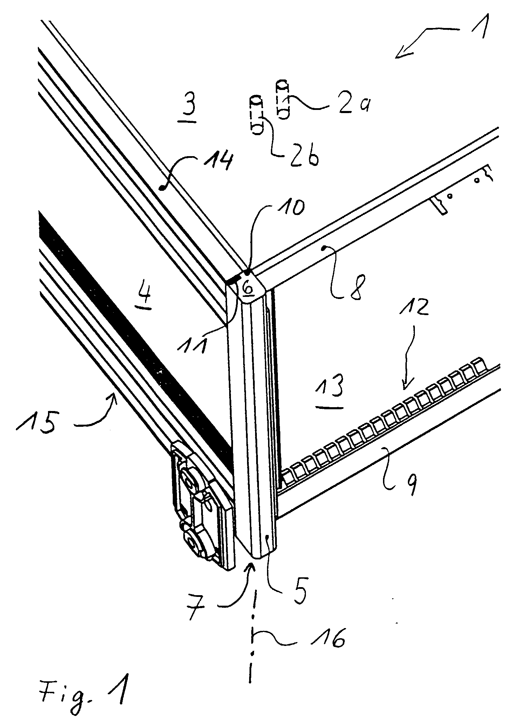

In Fig. 1 ist die linke Frontseite eines HF-dichten Baugruppenträgers 1 mit einer oberen Abdeckung 3, einer Seitenwand 4, einem Eckprofil 5, und einer unteren Abdeckung 13 gezeigt.

Das obere ebene Ende 6 des Eckprofils 5 bildet zusammen mit der oberen Abschlußfläche 14 der Seitenwand 4 und der oberen Abdeckung 3 des erfindungsgemäßen HF-dichten Baugruppenträgers zwei Abschlußbereiche mit der oberen Abschlußfläche 14 und der oberen Abdeckung 3. Die der oberen Abdeckung 3 zugewandte Ecke des Eckprofils 5 ist im Abschlußbereich der Ecke des Eckprofils 5 mit der Ecke der oberen Abdeckung 3 mit einer Aussparung 10 versehen, die etwa einen hakenförmigen Querschnitt aufweist und sich von oben nach unten erstreckt. Der Bereich der Erstreckung der Aussparung 10 ist vorzugsweise etwa auf die Länge und Ausdehnung einer Aussparung 11 des Eckprofils 5 beschränkt, weil sich dann bei dieser bevorzugten Ausführungsform die Möglichkeit ergibt, zwei in ihren Abmessungen identische HF-Dichtungen 2a und 2b zu verwenden. Dies vereinfacht die Lagerhaltung und auch die Montage. Die Aussparung 11 im Eckprofil 5 ist im Bereich der Stoßflächen des Eckprofils 5 und der angrenzenden oberen Abschlußfläche 14 der Seitenwand 4 vorgesehen, wobei sich die Längsachse der Aussparung 11 auf einer Ebene erstreckt, die weitgehend parallel zum ebenen oberen Ende 6 des Eckprofils 5 verläuft. Demgegenüber verläuft die Längsachse der Aussparung 10 etwa parallel zur Längsachse 16 des Eckprofils 5.

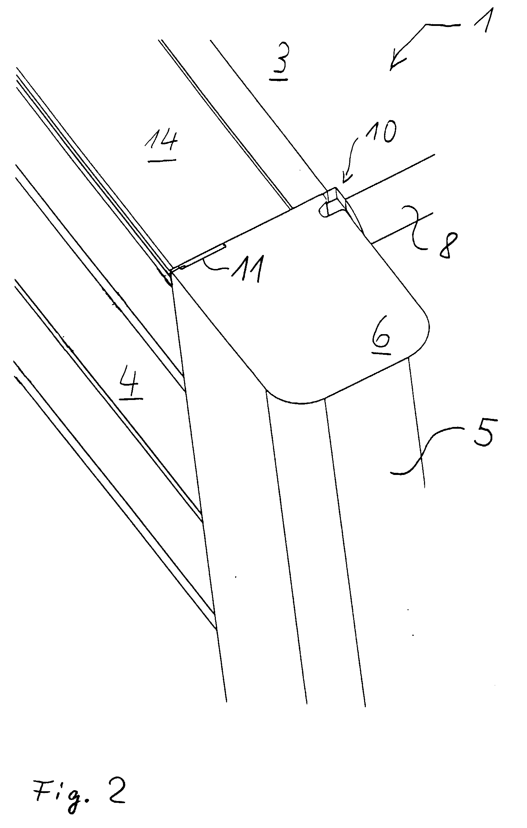

Vor dem Zusammenfügen der Seitenwand 4 mit dem Eckprofil 5 wird die HF-Dichtung 2b in die Aussparung 11 eingelegt, wobei die Aussparung vorzugsweise Abmessungen hat, die geringfügig kleiner als die Ausdehnungen der HF-Dichtung 2b sind, um so zu erreichen, daß die HF-Dichtung 2b nach dem Eindrücken in die Aussparung zur Vereinfachung der Montage gehalten wird. Nachfolgend bilden die obere Abschlußfläche 14 der Seitenwand 4, die HF-Dichtung 2b und das obere Ende 6 des Eckprofils 5 eine weitgehend bündige Oberfläche. Nachfolgend wird die HF-Dichtung 2a in die Aussparung 10 am Eckprofil 5 eingelegt, wobei der Durchmesser der Aussparung 10 geringfügig geringer ist als der Durchmesser der HF-Dichtung 2a, so daß auch diese HF-Dichtung 2a nach dem Eindrücken in die Aussparung 10 gehalten wird, was die Montage der oberen Abdeckung 3 des Baugruppenträgers 1 erleichtert. Es versteht sich, daß die Aussparungen 10 und 11 und entsprechend die HF-Dichtungen 2a und 2b auch eine - einander angepaßte - andere Gestalt haben können, solange in diesen Bereichen eine ausreichende HF-Abdichtung des Baugruppenträgers 1 ermöglicht ist. Ebenso kann die Aussparung 11 derart angeordnet sein, daß diese nicht nach oben offen ist, wie in Fig. 2 dargestellt, sondern knapp unterhalb des oberen Endes 6 des Eckprofils 5 liegt. Wichtig für die Anordnung und die Abmessungen der Aussparungen 10 und 11 und für die Abmessungen der HF-Dichtungen 2a und 2b ist, daß ein guter (elektrischer) Kontakt zwischen dem vorzugsweise metallischen Eckprofil 5, der metallischen Seitenwand 4 und der metallischen Abdeckung 3 und/oder ein möglichst spaltenfreier Übergang zwischen den Elementen des Baugruppenträgers erreicht ist. Bei derartigen Baugruppenträgern werden üblicherweise Baugruppenträgerelemente aus Aluminium und/oder Stahl verwendet.

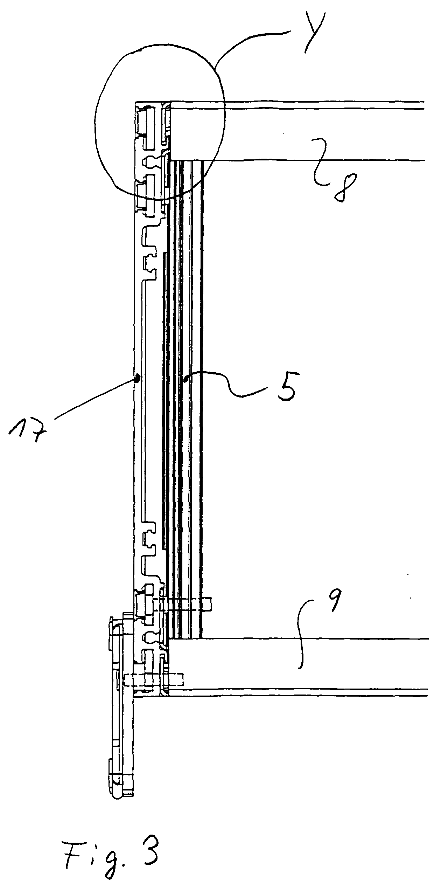

Aus Fig. 3 ist ersichtlich, dag die dem Eckprofil 5 zugewandte Schmalseite der Seitenwand 4 eine ebene Kontaktfläche 17 bildet, die über ihre gesamte Länge die Oberfläche des Eckprofils 5 berührt und so im gesamten Kontaktbereich für eine gute HF-Abdichtung sorgt.

Es versteht sich, daß die beschriebene Anordnung von HF-Dichtungen am oberen Ende des Eckprofils 5 vorzugsweise auch am unteren Ende im Abschlußbereich des Eckprofil 5 mit der Seitenwand 4 und der unteren Abdeckung 13 in entsprechender Form vorgesehen sein kann. Weiterhin können selbstverständlich auch nur die Front-Ecken des Baugruppenträgers 1 oder auch alle vier Ecken des Baugruppenträgers mit dem beschriebenen Eckprofil 5 versehen sein.

Bei den HF-Dichtungen 2a und 2b handelt es sich, wie auch bei den nachfolgend beschriebenen HF-Dichtungen, vorzugsweise um HF-Dichtungen aus Kupfer, Kupfer-Beryllium oder ein elektrisch leitendes elastisches Material, wie Silikonelastomer.

Im Frontbereich des Baugruppenträgers 1 sind Kontaktzungenkörper 12 vorgesehen, die vorzugsweise in weitgehend äquidistanten Abständen rund um den Öffnungsbereich der Frontseite des Baugruppenträgers 1 angeordnet sind. Der Kontaktzungenkörper 12 weist Kontaktzungen auf, die sich schräg nach oben bzw. schräg nach unten (nicht dargestellt) in die frontseitige Öffnung des Baugruppenträgers 1 hinein erstrecken. Eine solche Anordnung von Kontaktzungenkörpern 12 kann ebenso auf der Rückseite des Baugruppenträgers 1 vorgesehen sein. Durch derartige Kontaktzungenkörper 12 ist es möglich, für eine gute HF-Abdichtung im frontseitigen bzw. rückseitigen Bereich des Baugruppenträgers 1 zu sorgen, wenn die Kontaktzungenkörper 12 nach der Montage der frontseitigen Abdeckung (nicht dargestellt) bzw. der rückseitigen Abdeckung (nicht dargestellt) mit den Kontaktzungen der Kontaktzungenkörper 12 in einen mechanischen Kontakt treten. Um dies zu erreichen, ist die Frontabdeckung und auch die rückseitige Abdeckung mit hochgezogenen schmalen Wänden versehen, so daß die vordere und rückwärtige Abdeckung (nicht dargestellt) eine wannenartige Form aufweist. Ebenso kann im Frontbereich oder im rückwärtigen Bereich eine solche beschriebene Abdeckung oben, oder an einer der Seiten des Frontbereichs des Baugruppenträgers 1, angelenkt sein (nicht dargestellt). Durch die vorstehend beschriebene Lösung, ist der Frontbereich aufgrund der beschriebenen Anordnungen der HF-Dichtungen, der sich im gesamten frontseitigen Öffnungsbereich des Baugruppenträgers 1 erstreckenden Kontaktzungenkörper 12, die auch an dem bzw. den Eckprofilen 5 vorgesehen sind, bei der Verwendung von sogenannten EMV-Frontplatten komplett geschlossen und gut gegen HF-Einstrahlung abgeschirmt.

Im Zusammenhang mit den nachfolgenden Figuren werden weitere optionale Maßnahmen zur Erhöhung der HF-Dichtigkeit bzw. zur Erhöhung des EMV-Schutzes des Baugruppenträgers 1 angegeben.

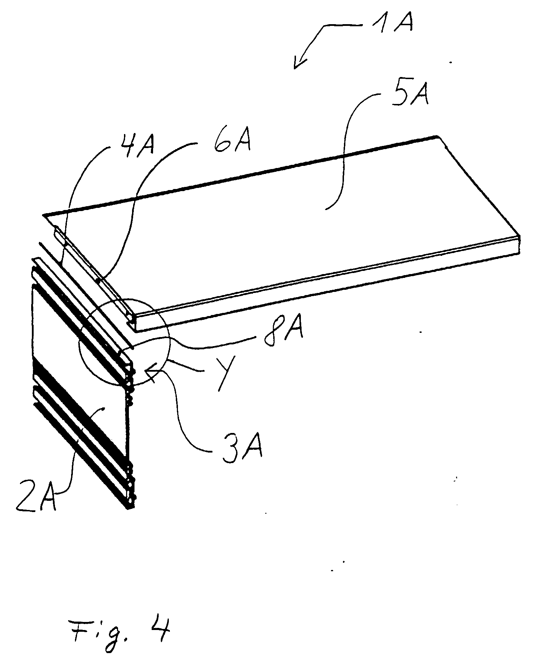

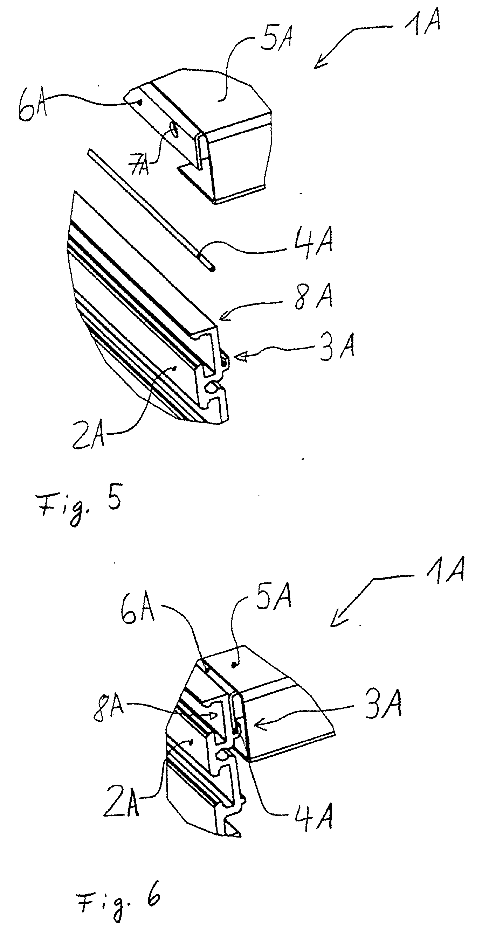

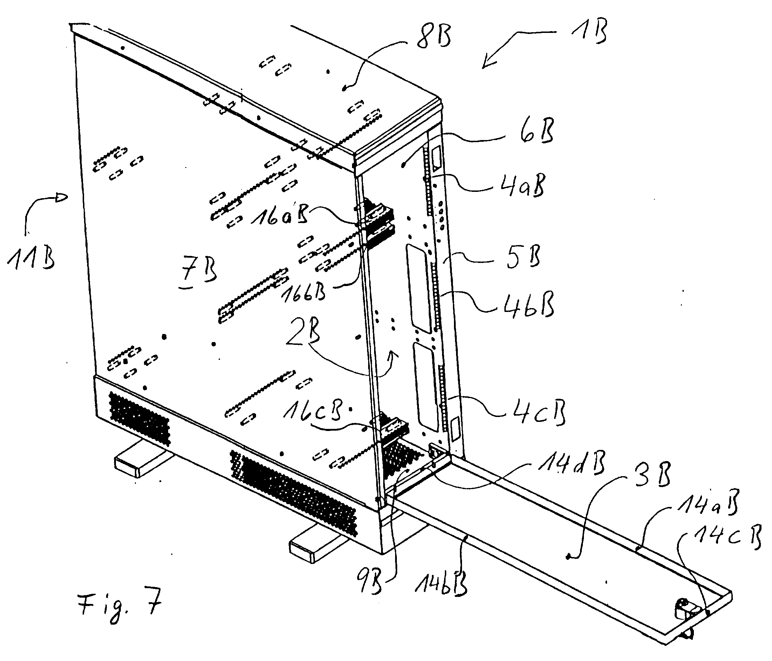

Fig. 4 zeigt die linke Seitenwand 2A eines Baugruppenträgers 1A, eine HF-Dichtung 4A und eine obere Abdeckung 5A des Baugruppenträger 1A. Auf der Innenseite der Seitenwand 2a erstreckt sich eine an die Seitenwand 2a angeformte Rinne 3A, die sich parallel zur Oberkante der Seitenwand 2A erstreckt. Es versteht sich, daß die vorgenannte Rinne 3A nicht notwendigerweise an die Innenseite der Seitenwand 2A angeformt sein muß, sondern auch in anderer Weise und in einer anderen Form gestaltet sein kann. In die Rinne 3A wird bei der Montage des Baugruppenträgers 1A die HF-Dichtung 4A eingelegt, deren Querschnitt vorzugsweise etwas größer ist als der Querschnitt der Rinne 3A, so daß die HF-Dichtung 4A nach dem Eindrücken in die Rinne 3A sicher von der Rinne gehalten wird. Nachfolgend wird bei der Montage des Baugruppenträgers 1A die obere Abdeckung 5A auf die Seitenwand 2A aufgelegt und die Unterkante einer sich etwa senkrecht zur Oberfläche der oberen Abdeckung 5A erstreckenden Befestigungsleiste 6A, die an der oberen Abdeckung 5A angebracht ist bzw. einstückig an diese angeformt ist, liegt auf der HF-Dichtung 4A über die gesamte Breite der Seitenwand 2A auf und liegt in der Rinne 3A, wie in Fig. 6 dargestellt.

Hieran ist von Vorteil, daß keine Schrauben zur Herstellung des EMV-Kontakts zwischen der oberen Abdeckung und der Seitenwand notwendig sind, da die Abdeckung durch ihr Eigengewicht auf dem EMV-Dichtmaterial bzw. der HF-Dichtung aufliegt. Die Abdeckung kann demontiert werden, ohne daß die Abdeckung am Dichtmaterial entlangkratzt. Eine gute EMV-Schirmung wird auch über längere Kontaktflächen erreicht, da die Stirnfläche auf dem EMV-Dichtmaterial aufliegt und dieses auch Unebenheiten ausgleicht. Vorzugsweise handelt es sich bei der HF-Dichtung 4A um ein Silikonelastomer. Es könnte jedoch auch beispielsweise ein Kupfer- oder Kupferberyllium-Stab oder auch ein anderes geeignetes Material Verwendung finden. Es versteht sich, daß die Rinne 3A auch eine andere Querschnittsform aufweisen könnte. Ebenso wäre es möglich, die Rinne 3A, die sich entsprechend der Figuren 5 und 6 durchgängig über die gesamte Breite der Seitenwand erstreckt, mit einer Vielzahl unterbrochener Rinnen und entsprechend kürzerer HF-Dichtungen zu realisieren. Dies wird sich insbesondere daran orientieren, ob eine ausreichende HF-Abschirmung schon mit geringerem Materialeinsatz möglich ist. Vorzugsweise erstreckt sich die HF-Dichtung 4A wie auch die Rinne 3A über die gesamte Breite der Seitenwand 2A.

Es versteht sich ebenso, daß die vorgenannte EMV-Abschirmung an der oberen Abdeckung 5A des Baugruppenträgers 1A auch an der Ober- und Unterseite und auch an einer rechten Seitenwand (nicht dargestellt) vorgesehen sein kann. Bei einer zu den Figuren 4-6 analogen Anordnung einer unteren Abdeckung (nicht dargestellt) versteht es sich, daß sich eine Anordnung ergibt, die etwa der Anordnung entspricht, die man erhält, wenn die Figuren 4-6 um 180° gedreht werden. Um zu verhindern, daß bei einer solchen Anordnung der unteren Abdeckung (nicht dargestellt) diese aus der Rinne herausrutscht, wird eine durch die Seitenwand des Baugruppenträgers 1A hindurchgehende Blechschraube oder dergleichen in eine der Blechschraube angepaßte Bohrung 7A eingeschraubt, die dieses Ende der unteren Abdeckung hält. Es versteht sich, daß mindestens eine weitere entsprechende Befestigungsanordnung auch an der anderen Seite vorgesehen wird. Vorzugsweise wird mit der Befestigung der unteren Abdeckung (nicht dargestellt) über die Bohrung 7A der in Fig. 1 dargestellte Aufstellfuß an den Baugruppenträger angeschraubt.

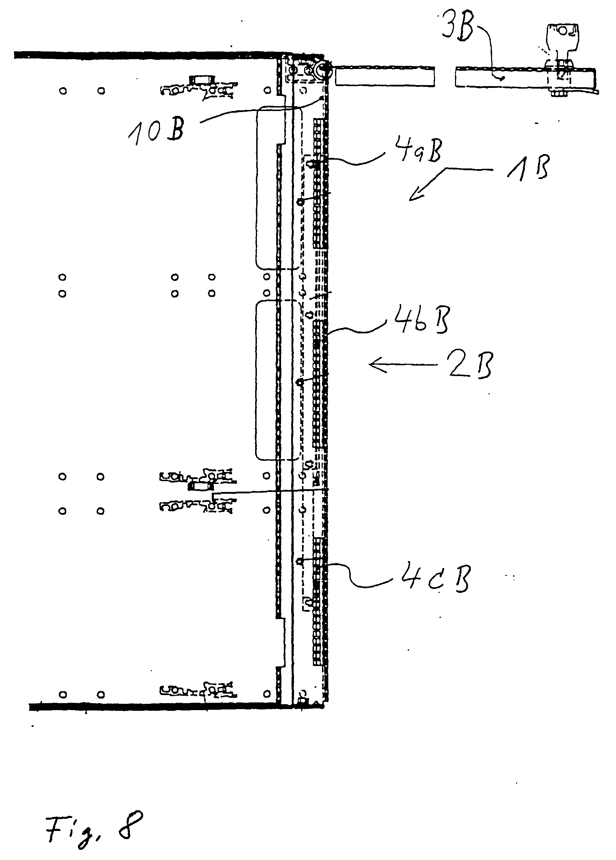

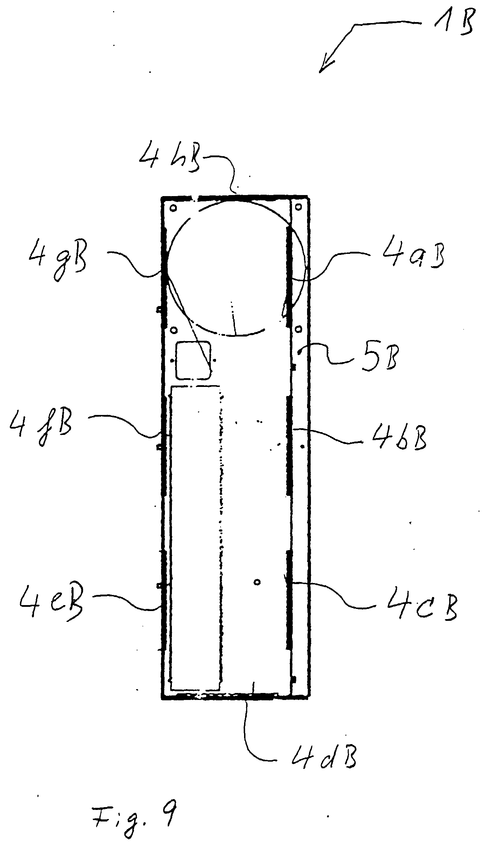

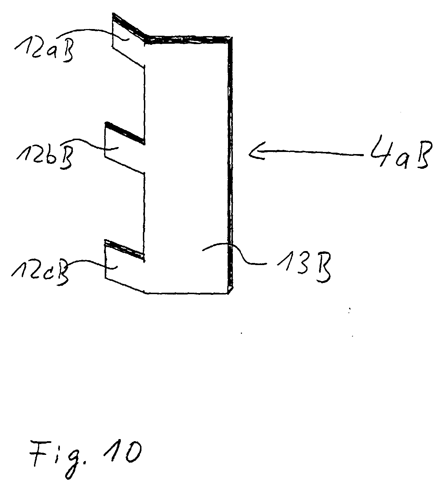

Fig. 7 zeigt als weitere Maßnahme zur Erhöhung der HF-Abschirmung bzw. EMV-Abschirmung einen HF-dichten Baugruppenträger mit einer Tür an der Frontseite und Kontaktzungenkörper entsprechend dem Kontaktzungenkörper 12 in Fig. 1, d. h., die Kontaktzungenkörper 4aB bis 4hB. Bei dem in den Figuren 7-9 dargestellten Baugruppenträger 1B handelt es sich um einen auf eine seiner Schmalseiten gestellten Baugruppenträger in einer sogenannten Toweranordnung. Der Baugruppenträger 1B weist eine linke Seitenwand 7B, eine rechte Seitenwand 6B, eine obere Abdeckung 8B, eine untere Abdeckung 9B und eine Rückwand 11B auf. Mit dem Bezugszeichen 2B ist die Türöffnung des Baugruppenträgers 1B bezeichnet. An der unteren Schmalseite ist im Türöffnungsbereich 2B eine Tür 3B angelenkt. Hinter dem "Türrahmen" im Frontbereich des Baugruppenträgers 1B ist eine hinter dem Türrahmen umlaufende Klemmleiste 10B angeordnet, die zusammen mit dem Türrahmen bzw. der Schalterleiste 5B eine Klemmvorrichtung schafft, in die Kontaktzungenkörper entsprechend dem der schematisierten Darstellung in Fig. 10, eingeschoben und klemmend gehalten werden. Bevorzugt werden die Kontaktzungenkörper in äquidistanten Abständen rund um den Türöffnungsbereich angeordnet (Fig. 9) und die gegenüber der Klemmplatte 13B des Kontaktzungenkörper 4aB abgewinkelten Zungen 12aB-12cB weisen im montierten Zustand schräg nach hinten in den Türöffnungsbereich 2B hinein.

Wird nun die mit hochgezogenen Wänden 14aB-14dB versehene Tür 3B geschlossen, so drücken die hochgezogenen Wände der Tür die Kontaktzungenkörper 4aB-4hB beiseite und es ergibt sich ein guter mechanischer Kontakt zwischen dem Frontbereich des Baugruppenträgers 1B und der Tür 3B, so daß auch bei Baugruppenträgern, die eine Tür aufweisen, eine gute EMV-Abschirmung erreicht werden kann. Um weiterhin einen Norm-Baugruppenträger verwenden zu können, wie beispielsweise einen 19"-Baugruppenträger, ist vorgesehen, die Befestigungsebene von in dem Baugruppenträger 1B angeordneten Leiterplatten, wie Europakarten mit Frontplatten 16aB-16cB, in Richtung der Rückseite 11B des Baugruppenträgers 1B zu versetzen, damit die Tür 3B den Baugruppenträger 1B verschließen kann. Bei den Kontaktzungenkörpern 4aB-4hB handelt es sich vorzugsweise um Kontaktzungenkörper aus Kupfer oder Kupferberyllium, die entsprechend Fig. 9 in etwa äquidistanten Abständen hinter dem "Türrahmen" der Frontseite des Baugruppenträgers 1B am Baugruppenträger 1B angeordnet sind. Es versteht sich, daß die Kontaktzungenkörper nicht notwendigerweise in der vorstehend beschriebenen Klemmvorrichtung rund um den Öffnungsbereich des Baugruppenträgers 1B angeordnet sein müssen, sondern dort beispielsweise auch bei Verwendung einer für HF-Anwendungen geeigneten Klebers angeklebt oder auch festgeschraubt sein können. Dies wird sich insbesondere auch daran orientieren, ob bei der konkreten Gestaltung eine ausreichende EMV-Abschirmung im Frontbereich erreicht werden kann. Es versteht sich, daß anstelle einer aufklappbaren Tür 3B auch eine der Tür 3B weitgehend entsprechende Frontplatte (nicht dargestellt) Verwendung finden kann. Bei einer solchen Anordnung, sei es nun unter Verwendung einer Tür oder einer Frontplatte, ist von Vorteil, dag die in dem Baugruppenträger installierten Einzelbaugruppen, wie die Leiterplatten bzw. Europakarten 16aB-16cB, keinen Einzel-EMV-Schutz zur Frontseite hin benötigen, da dieser durch die EMV-Tür 3B bzw. durch eine entsprechende Frontplatte (nicht dargestellt) herbeigeführt wird. Bei Verwendung der Tür 3B ergibt sich der Vorteil, daß diese nach dem Öffnen den Zugriff auf die in dem Baugruppenträger 1B angeordneten Leiterplatten usw. freigibt, so daß diese leicht entnommen und gegen andere ausgetauscht werden können. Dies ist beispielsweise bei Versuchsaufbauten im Labor von Vorteil.

Es versteht sich, daß alle der vorgenannten Maßnahmen zur Erhöhung der HF-Abschirmung oder auch nur ein Teil der genannten Maßnahmen bei einem erfindungsgemäßen HF-dichten Baugruppenträger realisiert sein können. Dies wird sich insbesondere daran orientieren, welche Anforderungen an den konkret herzustellenden Baugruppenträger hinsichtlich seiner HF-Dichtigkeit bzw. EMV-Abschirmung gestellt werden und unter der weiteren Randbedingung, einen solchen Baugruppenträger mit minimalem Kostenaufwand zu realisieren.

### Bezugszeichenliste

- 1: Baugruppenträger
- 2a: HF-Dichtung
- 2b: HF-Dichtung
- 3: obere Abdeckung
- 4: Seitenwand
- 5: Eckprofil
- 6: oberes Ende des Eckprofils 5
- 7: unteres Ende des Eckprofils 5
- 8: Frontprofil der oberen Abdeckung
- 9: Frontprofil der unteren Abdeckung
- 10: Aussparung
- 11: Aussparung
- 12: Kontaktzungenkörper
- 13: untere Abdeckung
- 14: obere Abschlußfläche der Seitenwand 4
- 15: untere Abschlußfläche der Seitenwand 4
- 16: Längsachse des Eckprofils 5
- 17: Kontaktfläche der Seitenwand 4 mit dem Eckprofil 5

## Patentansprüche

1. Baugruppenträger (1), insbesondere ein 19"-Gehäuse, mit einer ersten Seitenwand (4), einer zweiten Seitenwand, einer Rückwand, einer oberen Abdeckung (3), einer unteren Abdeckung (13) und einer Frontabdeckung, wobei im Baugruppenträger mindestens eine HF-Dichtung (2a, 2b) vorgesehen ist,
**dadurch gekennzeichnet,**
daß
- der Baugruppenträger (1) mindestens ein Eckprofil (5) aufweist und
- das Eckprofil (5) im Abschlußbereich mit der oberen und/oder der unteren Abdeckung (3, 13) und/oder im Abschlußbereich mit der oberen und/oder der unteren Abschlußfläche (14, 15) einer Seitenwand (4) mit mindestens einer Aussparung (10, 11) zur Aufnahme jeweils einer HF-Dichtung (2A, 2B) - oder umgekehrt - versehen ist.

2. Baugruppenträger nach Anspruch 1,
**dadurch gekennzeichnet,**
daß sich eine erste Aussparung (10) zur Aufnahme einer ersten HF-Dichtung (2A) im Abschlußbereich des Eckprofils (5) mit der oberen und/oder unteren Abdeckung (3, 13) parallel versetzt zur Längsachse (16) des Eckprofils (5) erstreckt.

3. Baugruppenträger nach Anspruch 1 oder 2,
**dadurch gekennzeichnet,**
daß sich eine zweite Aussparung (11) zur Aufnahme einer zweiten HF-Dichtung (2B) im Abschlußbereich des Eckprofils (5) mit der oberen und/oder der unteren Abschlußfläche (14, 15) der Seitenwand (4) erstreckt.

4. Baugruppenträger nach einem der Ansprüche 1-3,
**dadurch gekennzeichnet,**
daß eine Schmalseite der Seitenwand (4) weitgehend über ihre gesamte Länge eine Kontaktfläche (17) mit dem Eckprofil (5) bildet.

5. Baugruppenträger nach einem der Ansprüche 1-4,
**dadurch gekennzeichnet,**
daß an jeder der vier Ecken des Baugruppenträgers (1) ein Eckprofil (5) vorgesehen ist.

6. Baugruppenträger nach einem der Ansprüche 1-4,
**dadurch gekennzeichnet,**
daß an jeder der zwei Ecken im Frontbereich des Baugruppenträgers (1) ein Eckprofil (5) vorgesehen ist.

7. Baugruppenträger nach einem der Ansprüche 1-6,
**dadurch gekennzeichnet,**
daß das Eckprofil (5) einen weitgehend quadratischen oder rechteckigen Querschnitt aufweist.

8. Baugruppenträger nach einem der Ansprüche 1-7,
**dadurch gekennzeichnet,**
daß eines oder mehrere der in den Ansprüchen 1-7 genannten Elemente des Baugruppenträgers (1) ganz oder teilweise aus Aluminium, Stahl oder einem anderen EMV-abschirmenden bzw. HF-abschirmenden Material besteht.
